# EUROPEAN PATENT APPLICATION

(11) **EP 4 576 166 A1**
(43) Date of publication of application: **25.06.2025**
(21) Application number: 23220054.3
(22) Date of filing: 22.12.2023
(51) Int. Cl.: H01L 21/02, H01L 21/762, H01L 21/8234, H01L 21/8238, H01L 29/66

(54) **A SEMICONDUCTOR STRUCTURE AND A METHOD FOR FORMING A SEMICONDUCTOR STRUCTURE**

(71) Applicant: Imec VZW, 3001 Leuven (BE); Tokyo Electron Limited, Tokyo 107-6325 (JP)
(72) Inventor: CHAN, Boon Teik, 3012 Wilsele (BE); DEMUYNCK, Steven, 3200 Aarschot (BE); SEPULVEDA MARQUEZ, Alfonso, 3000 Leuven (BE); MATSUKI, Nobuo, Nirasaki-city, 407-0192 (JP)
(74) Representative: AWA Sweden AB

(57) **Abstract**

The present disclosure relates to a method (1000) for forming a semiconductor structure, the method (1000) comprising: forming (1100) a first and second fin separated by a trench, the first and second fin each comprising at least one channel layer, being a channel layer for a field effect transistor; and forming (1200) a shallow trench isolation structure, STI structure, at a bottom of the trench, wherein the STI structure comprises a layer of a silicon-carbon compound.

## Description

### TECHNICAL FIELD

The present inventive concept relates, in general, to a semiconductor structure and a method for forming a semiconductor structure and a shallow trench isolation structure.

### BACKGROUND

Semiconductor devices, particularly field-effect transistors (FETs), are fundamental components in modern electronic devices. The performance of such devices is largely dependent on the design and fabrication of the semiconductor structure. Various methods have been developed to improve the efficiency and functionality of these structures.

One such method involves the formation of fin structures, which are thin, vertical semiconductor bodies on which the gate of the FET is formed. These fin structures, which include channel layers, allow for better control of the current flow through the channel, thereby improving the performance of the FET.

The process of forming these fin structures often involves the formation of a trench between the fins. At the bottom of the trenches a shallow trench isolation (STI) is often used.

### SUMMARY

It is an objective of the present inventive concept to provide improved semiconductor structures and/or FET.

It is a further objective to provide strong and/or durable and/or stable semiconductor structures and/or FETs.

It is a further objective to facilitate semiconductor structures and/or FETs which are small and/or are densely packed.

It is a further objective to facilitate high yield in the production of semiconductor structures and/or FETs.

It is a further objective to facilitate simple production of semiconductor structures and/or FETs.

It is a further objective of the present inventive concept to improve shallow trench isolation of semiconductor structures and/or FETs.

These and other objectives of the inventive concept are at least partly met by the invention as defined in the independent claims. Preferred embodiments are set out in the dependent claims.

According to a first aspect there is provided a method for forming a semiconductor structure. The method comprises: forming a first and second fin separated by a trench, the first and second fin each comprising at least one channel layer, being a channel layer for a field effect transistor; and forming a shallow trench isolation structure, STI structure, at a bottom of the trench, wherein the STI structure comprises a layer of a silicon-carbon compound .

The semiconductor structure may be a semiconductor structure for producing a set of FETs. Thus the semiconductor structure may be a semiconductor structure suitable to be converted into a set of FETs. Thus, the semiconductor structure may later become part of, e.g., an electronic device.

The first and second fin may comprise a respective layer stack comprising semiconductor layers. As mentioned, each fin comprises at least one channel layer. The channel layer is a channel layer for a FET. The channel layer may be a semiconductor layer. The channel layer may be a silicon layer. Accordingly, each fin may later be converted into at least one FET. Thus, the first and second fin may later be converted into at least two FETs.

Additionally, each fin may comprise sacrificial layers. The sacrificial layers may be layers intended to be replaced with other features during production of FETs. For example, each channel layer may have a neighboring first sacrificial layer which later may be replaced with a gate stack. The sacrificial layers may be semiconductor layers of a different material than the channel layers. Each channel layer may be sandwiched between two neighboring first sacrificial layers.

Each FET may comprise several channel layers. Thus, each fin may comprise a first sub-stack comprising alternating channel layers (e.g. of Si) and first sacrificial layers (e.g. of SiGe). More specifically, the first sacrificial layers may be formed of SiGe (e.g. Si₁₋ₓGeₓ, wherein x>0.1) and the channel layers may be formed of Si, wherein the first sacrificial layers may later be removed selectively to the channel layers and replaced by gate stacks. In other words, etching processes may allow for SiGe to be etched with a relatively high selectively to Si, such that the sacrificial layers may be removed selectively to the channel layers.

Each fin may be a fin suitable for production of several FETs, e.g. a stack of FETs. Accordingly, each fin may comprise a first sub-stack, a second sub-stack on top of the first sub-stack, and a third sub-stack on top of the second sub-stack. The first and third sub-stacks may respectively comprise alternating first sacrificial layers and channel layers. Thus, channel layers of the first sub-stack may later become channel layers of a bottom FET and channel layers of the third sub-stack may later become channel layers of a top FET. The second sub-stack may comprise at least one second sacrificial layer of a different material than the first sacrificial layer. The second sacrificial layer may be a layer which may later be replaced with an isolating layer, e.g. a so called middle dielectric isolation, suitable to isolate the top FET from the bottom FET. For example, the first sacrificial layers may comprise Si₁₋ₓGeₓ, wherein 0.1 <x<0.25 and the second sacrificial layers may comprise Si_{1-y}Ge_{y}, wherein 0.35<y<0.5.

The STI structure may be a structure configured to prevent current, e.g. leakage current, from running between the first and second fin. In other words, the STI structure may isolate the first fin from leakage current of the second fin, and vice versa. The STI structure may be a structure of dielectric material. As mentioned the STI structure comprises a layer of silicon-carbon compound. The STI structure may comprise solely the layer of silicon-carbon compound. Alternatively, the STI structure may comprise further layers, e.g. further dielectric layers.

The silicon-carbon compound may be a compound made up of at least silicon and carbon atoms. In particular, the silicon-carbon compound may be a compound comprising silicon-carbon bonds and/or a crystalline silicon-carbon compound.

It is a realization that fins may collapse during production of FETs. This may reduce the yield of the produced FETs. The risk of fin collapse may be particularly high when the fins are small, e.g. thin, and/or when densely packed FETs are produced. It is a further realization that fin collapse may, at least partially, be caused by degradation or loss of parts of the STI structure during later production steps. In particular, parts of the STI structure may be lost during source/drain recessing, i.e. when trenches are etched at the ends of the fins in order to epitaxially grow source/drain regions. The etch used for the source/drain recessing may attack also the STI structure.

The silicon-carbon compound may decrease a usage of STI oxides such as SiO₂. It is a realization that SiO₂ may be sensitive to the source/drain recessing etch. In particular, it is a realization that SiO₂ deposited by flowable chemical vapor deposition (FCVD) may be sensitive to the source/drain recessing etch. Thus, an etch resistant STI structure may be provided. The silicon-carbon compound may further be strong, i.e. hard and durable. Hereby, a strong STI structure may be provided. Consequently, a final fin width could be reduced due to the etch resistant and/or the strong STI structure. Further, when the fin width is small, the FETs may be packed more densely. Further, a fin height may be higher due to the etch resistant and/or strong STI structure. If the STI structure is weak, the fin height may need to be limited to avoid fin collapse. A higher fin may facilitate more FETs being stacked on top of each other. Further, the production method may be simple as the silicon-carbon compound may alleviate the need for other means to reduce the risk of fin collapse.

The layer of silicon-carbon compound may protect the STI structure during a manufacturing process of a FET. In particular, the silicon-carbon compound may protect the STI structure during etching for the source/drain recess. Thus, facilitated fabrication of semiconductor structures may be provided.

A top surface of the layer of silicon-carbon compound may define a top surface of the STI structure. Thus, the silicon-carbon compound may protect, e.g. from an etch, parts of the STI structure arranged below the layer of the silicon-carbon compound. Accordingly, it may not be necessary to make the entire STI structure of the silicon-carbon compound. It may be sufficient to use a layer, e.g. a top layer of silicon-carbon compound on another dielectric layer.

The layer of silicon-carbon compound may be incorporated to adjust a composition of the SiO₂ used in the STI and/or enhance the STI's resilience to fabrication steps, thus ensuring better preservation of the STI structure and improving integrity of the semiconductor structure. Hereby, an amount of STI material lost when creating the source/drain recess and during multiple cleaning processes, e.g., involving diluted hydrofluoric solutions, may be reduced.

Forming the STI structure may comprise forming the layer of silicon-carbon compound by a first chemical vapor deposition method, CVD method. The first CVD method may comprise: reacting, as a film-forming gas, an oxygen-containing silicon compound gas with a non-oxidizing hydrogen-containing gas in a state in which at least the non-oxidizing hydrogen-containing gas is plasmarized, to form a film of a flowable silanol compound; and subsequently, annealing the semiconductor structure to turn the film of flowable silanol compound into the layer of silicon-carbon compound. The oxygen-containing silicon compound gas may comprise Si_{α}O_{β}(O-CₘHₙ)_{Γ}CₓH_{y}, wherein m, n, and α are integers of 1 or more; and wherein β, Γ, x, and y are integers of 0 or more; and β and Γ are not 0 at the same time.

The first CVD process is described in US20220235456A1 , which is hereby incorporated by reference. In particular, the detailed description of US20220235456A1 is incorporated by reference.

The oxygen-containing silicon compound gas may react with the plasmarized hydrogen-containing gas to deposit the silanol compound. This compound may be further modified by adding gases like methyltrimethoxysilane or an oxygen-free silicon compound to introduce hydrocarbon groups or reduce oxygen content. The annealing step solidifies the silanol compound, forming a robust insulation layer.

In other words, the first CVD method may involve a two-step process where a film-forming reaction occurs. The reaction may use an oxygen-containing silicon compound gas and a plasmarized non-oxidizing hydrogen-containing gas to create a flowable silanol compound film on a semiconductor structure. The semiconductor structure may have a surface topology comprising trenches to accommodate the film. After the deposition, the film may undergo annealing for converting the flowable silanol compound into a stable layer, thus being integral to the semiconductor's structure.

The first CVD method may be called ultra-chemical vapor deposition (UCVD) method or Chemical Vapor Liquid Deposition method. In the following description the term UCVD will primarily be used.

Hereby, forming of STI structures may be simplified by applying the UCVD method. The UCVD method may provide a silicon-carbon compound with few voids, e.g. a void free silicon-carbon compound. When there are few voids a strong STI structure is facilitated. Similarly, when there are few voids a STI structure with good electrical properties is facilitated. The UCVD method may particularly facilitate low annealing temperatures of the silicon-carbon compound and/or of the entire STI structure. Low annealing temperatures may facilitate production of the semiconductor structure. Low annealing temperatures may facilitate a better thermal budget.

The UCVD method may be particularly prone to deposit at the bottom of trenches. Thus, when using the UCVD method, the need for recessing of the STI structure may be reduced. This may also reduce or remove the need for chemical mechanical polishing (CMP). For example, the CMP step that may be used during production of SiO₂ STI structures may be skipped. When the CMP step is skipped it may also be possible to skip the use of a pad silicon nitride (Si3N4) hard mask for active patterning.

In particular, due to the layer of silicon-carbon compound, a hard mask for protecting certain areas during patterning processes is not needed, nor does CMP need to be utilized for planarization or to smoothen the semiconductor surfaces.

Annealing of the silicon-carbon compound may be performed at a temperature below 500 °C, preferably in a range of 350 °C - 500 °C.

In other words, a heat treatment process of the semiconductor structure and/or the silicon-carbon compound may not need to exceed 500 °C. In particular, a temperature in the range of 350 °C to 500 °C may be sufficient due to inherent properties of silicon-carbon compounds.

Thus, the silicon-carbon compound may not need to be annealed at a high temperature. Thereby diffusion of Ge from SiGe sacrificial layers (e.g. SiGe sacrificial layers for gate-all-around structures or middle dielectric isolation) may be low. In other words, unwanted diffusion may be decreased such that electronic properties of the semiconductor structure may be maintained.

Utilizing low-temperature annealing may further reduce thermal stress on the materials of the semiconductor structure. Thus decreasing a risk of damage or deformation which may occur at higher temperatures.

The relatively low temperature may further facilitate manufacturing of semiconductor structures as a Silicon Nitride (Si₃N₄) liner may be omitted since there may be no need for a high-temperature annealing step such as the one used for FCVD SiO₂. In particular, a Si₃N₄ liner might typically be used to protect underlying layers by withstanding the high temperature. However, owing to the silicon-carbon compound, and/or by utilizing UCVD with the silicon-carbon compound, desired properties may be achieved without the need for high-temperature annealing, hence rendering the Si₃N₄ liner unnecessary and simplifying the process of forming STI structures.

Alternatively, a thin silicon-carbon compound cap may be deposited by, e.g., atomic layer deposition (ALD) to provide etch protection. Here, the relatively low temperature may also be sufficient for annealing.

The silicon-carbon compound may be SiC, SiOC, and/or SiOCN.

In other words, the silicon-carbon compound may comprise silicon carbides, silicon oxycarbides, and/or silicon oxycarbonitrides. However, it is to be understood that the silicon-carbon compound may comprise other compounds and/or other silicon-carbon compounds.

It is appreciated that SiC, SiOC, and SiOCN each may have better etch resistance as compared to FCVD SiO₂. In particular, a compound exhibiting improved etch resistance compared to providing enhanced selectivity during etching processes, e.g. ensuring precise patterning. The robustness against etching further provides increased durability and reliability of the semiconductor structure. Consequently, this leads to a more efficient fabrication process of semiconductor structures having STI structures, e.g., through reduced time and costs associated with etching.

Forming of STI structures may, e.g., be simplified by applying the UCVD method with SiOC, or in other words, SiOC deposition.

The silicon-carbon compound may comprise 5-35% carbon.

In particular, the silicon-carbon compound is not limited to the compounds SiC, SiOC, and SiOCN, the silicon-carbon compound may be any material or compound constituted by 5-35% carbon. However, it is appreciated that the silicon carbon compound may comprise more than 35% carbon.

Silicon-carbon compounds containing 5-35% carbon may offer exceptional hardness and strength, high-temperature stability, chemical inertness, tailorable electrical properties, good thermal conductivity, and/or be lightweight. When the silicon-carbon compound comprises at least 5% carbon it provides good etch resistance and/or hardness to the STI structure. When the silicon-carbon compound comprises at most 35% carbon it provides good dielectric properties to the STI structure.

A height of the STI structure may be below 90 nm, preferably below 50 nm.

The height of the STI structure may refer to the depth of the STI structure in the trench between the fins of the semiconductor structure. The height of the STI structure may particular be the height to which the trench is filled with the silicon-carbon compound and/or a dielectric material, such as SiO₂. In other words, the height of the STI structure may be the height or depth of the material which isolates active areas of the semiconductor structure from one another.

It is a realization that a low height is facilitated by the method. For example the etch resistance of the silicon-carbon compound may reduce the need for tall STI structures to accommodate loss during source/drain recess. Thus a simplified production method is facilitated.

The act of forming the STI structure may comprise: depositing the layer of silicon-carbon compound, and stopping said act of depositing the layer of silicon-carbon compound before a top surface of the layer of silicon-carbon compound reaches the respective at least one channel of the first and second fin.

In other words, the layer of silicon-carbon compound may be deposited by bottom-up deposition. The bottom-up deposition may allow for selective filling of the trench between the first and second fin, that is the silicon-carbon compound may be deposited starting from a bottom portion of the first and second fin and progress upward along the fins to a predetermined distance.

Thus, there may not be a need for etch back of the silicon-carbon compound.

The bottom-up deposition may build the layer of the silicon-carbon compound atom by atom or molecule by molecule, thus allowing for precise control over the composition and structure of the STI structure. In particular, the silicon-carbon compound may be deposited layer by layer, e.g., starting at the bottom of the trench. Thus ensuring that the trench between the first and second fin is at least partly filled without any gaps or air pockets.

The bottom-up deposition may involve the first CVD method (i.e. the UCVD method).

The bottom-up deposition may reduce the need for recessing of the STI structure. This may also reduce or remove the need for chemical mechanical polishing (CMP). For example, the CMP step that may be used during production of SiO₂ STI structures may be skipped. When the CMP step is skipped it may also be possible to skip the use of a pad silicon nitride (Si₃N₄) hard mask for active patterning.

The method for forming the semiconductor structure may further comprise, subsequent to forming the STI structure: removing silicon-carbon compound from a top surface and lateral sides of the respective first and second fin; and forming gate dielectric on the top surface and the lateral sides of the respective first and second fin, said gate dielectric comprising a compound different from the silicon-carbon compound of the STI structure.

During the formation of the STI structure, a thin layer of the silicon-carbon compound may form on a top surface and on sidewalls (i.e. lateral sides) of the first and second fin. This layer of may subsequently be removed from the top surface and/or sidewalls of the fins.

The silicon-carbon compound may be removed from the top surface and/or lateral sides such that a gate oxide may be deposited on the top surface and/or lateral sides of the fins, e.g. through plasma-enhanced atomic layer deposition (PEALD), e.g. PEALD of SiO₂.

In other words, PEALD may be used to deposit a thin layer of SiO₂ to serve as a gate oxide on the semiconductor structure.

SiO₂ is a common insulating material used as a gate oxide in semiconductor structures. The gate oxide may separate a gate electrode from underlying semiconductor material. The gate oxide may, e.g., affect control of the flow of electrons between source and drain terminals of a transistor.

By removing the silicon-carbon compound from the top surface and lateral sides of the respective first and second fin, a production method is facilitated wherein another gate dielectric, e.g. a standard gate dielectric, is used.

Alternatively, the method for forming the semiconductor structure may further comprise: forming a silicon-carbon compound gate dielectric on a top surface and on lateral sides of the respective first and second fin, wherein the silicon-carbon compound gate dielectric comprises a same silicon-carbon compound as the STI structure and is formed simultaneously with the layer of silicon-carbon compound of the STI structure.

In other words, the thin layer of the silicon-carbon compound formed on the top surface and/or lateral sides of the first and second fin, e.g., by the UCVD method, may be kept to act as a gate oxide.

It is herein advantageous to deposit the silicon-carbon compound by UCVD. With this method the silicon-carbon compound may primarily deposit at the bottom of the trench, and simultaneously deposit only a thin layer on the top surface and/or the lateral sides of the respective first and second fin. It is a realization that this thin layer on the top surface and/or lateral sides of the respective first and second fin may be used as gate dielectric. This may simplify a manufacturing process of semiconductor structures.

However, the silicon-carbon compound may be deposited by other means, e.g. ALD. For example, a bottom part of the STI may be formed by depositing SiO₂ by FCVD and then recessing the SiO₂. A thin layer of silicon-carbon compound may then be deposited, e.g. by ALD, on top of the SiO₂ and also on the top surface and/or lateral sides of the respective first and second fin. Said silicon-carbon compound may then protect the SiO₂ of the STI during the manufacturing process, e.g. during etching for the source/drain recess. Hence, the silicon-carbon compound may act as gate dielectric on the top surface and/or lateral sides of the respective first and second fin.

The act of forming the layer of silicon-carbon compound of the STI structure, and the act of forming the silicon-carbon compound gate dielectric, may be performed by the first CVD method.

In other words, the layer of silicon-carbon compound of the STI structure and the silicon-carbon compound gate dielectric may both be formed or deposited by UCVD.

Hence, a simplified manufacturing process of the semiconductor structure may be provided.

The STI structure may comprise solely the layer of silicon-carbon compound.

In other words, the STI structure may be made of only the silicon-carbon compound. The silicon-carbon compound may thus be formed starting from the bottom of the trench between the first and second fin of the semiconductor structure. However, the semiconductor structure may further comprise a separate gate oxide as described above.

For example, UCVD void-free bottom-up deposition of the silicon-carbon compound (e.g., SiC, SiOC, and/or SiOCN), from the bottom of the trench, i.e. an STI floor, may be used. In particular, the UCVD of the silicon-carbon compound may be used instead of FCVD of SiO₂.

Hereby, only one deposition and no SiO₂ recess are needed, thus providing a simpler process for forming an STI. Further, a more robust semiconductor structure may be provided.

Silicon-carbon compounds may be deposited at room temperature and anneal at relatively low temperatures at described above, especially in comparison to FCVD of SiO₂.

Moreover, silicon-carbon compounds, such as SiC, SiOC, and/or SiOCN, have high etch resistance toward dry and/or wet chemistry. Thereby, a better selectivity to dry edge, i.e. an enhanced ability to precisely etch without affecting surrounding areas, may be provided.

Alternatively, the act of forming the STI structure may comprise: forming a layer of SiO₂ at the bottom of the trench, and forming the layer of silicon-carbon compound on the layer of SiO₂, such that the STI structure comprises the layer of SiO₂ and the layer of silicon-carbon compound.

In other words, the layer of silicon-carbon compound may cap the layer of SiO₂. Thus, a top surface of the SiO₂ may be protected by the silicon-carbon compound during further processing, e.g. during source/drain recess.

In this case, the layer of silicon-carbon compound may be thin, e.g. thinner than 10-50 nm, or preferably thinner than 30 nm.

Forming the layer of SiO₂ may be performed by depositing SiO₂ by flowable chemical vapor deposition in the trench and recessing the deposited SiO₂; and forming the layer of silicon-carbon compound is performed by the first CVD method.

In other words, the forming of the layer of SiO₂ may be performed by a second CVD method and the forming of the layer of silicon-carbon compound may be performed by the first CVD method.

Conventional FCVD of SiO₂ may be used. The use of SiO₂, e.g. FCVD deposited SiO₂, may facilitate manufacturing while the silicon-carbon compound cap provides etch resistance during source/drain recess.

Further, the capping layer of silicon-carbon compound may be formed by UCVD. Alternatively, the layer of silicon-carbon compound may be formed by other means, e.g. by ALD. In particular, a thin ALD layer may provide resistance to source/drain etch. Hence, a capping material may be introduced with a different deposition method.

By combining usage of FCVD of SiO₂, and UCVD of the silicon-carbon compound for capping, ease of implementation for the manufacturing may be provided.

For the FCVD deposition of SiO₂, well known methods may be used. UCVD capping by the silicon-carbon compound may then be added as an extra step to the conventional manufacturing process with minimal impact on the conventional process flow. UCVD may preferentially be deposited bottom-up in the trench. Thus, after the UCVD deposition of the silicon-carbon compound, there may be little or no silicon-carbon compound on the sides of the first and second fin. In such a situation, it is possible that little or no cleaning of the sides of the first and second fin is needed after the UCVD deposition.

The method for forming the semiconductor structure may further comprise: converting the first fin into a n-type field effect transistor, and converting the second fin into a p-type field effect transistor, or vice versa.

A n-type field effect transistor may be called a NFET. A p-type field effect transistor may be called a PFET.

Converting a fin into a field-effect transistors may comprise forming source/drain regions at opposite ends of the channel layer of the fin. The source/drain regions may be doped semiconductor regions, e.g. doped semiconductor regions adjacent to the end faces of the fin, e.g. doped semiconductor regions epitaxially grown on the end faces of channel layer.

For example, a n-doped semiconductor may be grown on the end faces of the first fin, during the process of converting the first fin into a NFET. Similarly, a p-doped semiconductor may be grown on the end faces of the second fin, during the process of converting the second fin into a PFET.

Source/drain regions may be formed before or after the gates are formed. Forming source/drain regions before forming the gate, i.e. in a gatelast process, is advantageous.

The NFET and PFET of the respective first and second fins may together form parts of a complementary circuit.

It should be understood that each fin may be converted into more than one FET, e.g. two FETs such as an NFET on-top of an NET or a PFET on-top of a PFET. For example, one fin may comprise an NFET on-top of an NFET and the other fin may comprise a PFET on-top of a PFET. Thus, the method for forming the semiconductor structure may comprise: converting the first fin into a first stack of field effect transistors and the second fin into a second stack of field effect transistors.

It should be understood that if each fin is converted into two FETs, said two FETs may comprise a NFET and a PFET. Thus, the method for forming the semiconductor structure may comprise: converting the first fin into a first stack of field effect transistors and the second fin into a second stack of field effect transistors, wherein each first and second stack of field effect transistors comprises a n-type field effect transistor and a p-type field effect transistor. A stack of FETs comprising a NFET and a PFET may be called a complementary FET (CFET).

Converting a fin into a CFET may comprise forming n-type source/drain regions at opposite ends of channel layers of the first FET (e.g. channel layers of a first sub-stack) and forming p-type source/drain regions at opposite ends of channel layers of the second FET (e.g. channel layers of a third sub-stack), or vice versa.

In view of the above, the method may further comprise:
converting the first fin into a n-type field effect transistor, and converting the second fin into a p-type field effect transistor; or
converting the first fin into a first stack of field effect transistors and the second fin into a second stack of field effect transistors, wherein each first and second stack of field effect transistors comprises a n-type field effect transistor and a p-type field effect transistor.

According to a second aspect, there is provided a semiconductor structure comprising: a first and second fin separated by a trench, the first and second fin each comprising at least one channel layer, being a channel layer for a field effect transistor; and a shallow trench isolation structure, STI structure, at a bottom of the trench, wherein the STI structure comprises a layer of a silicon-carbon compound.

The second aspect may generally present the same features and/or advantages, or similar advantages, as described in conjunction with the first aspect.

### BRIEF DESCRIPTION OF THE DRAWINGS

The above, as well as additional objects, features and advantages of the present inventive concept, will be better understood through the following illustrative and non-limiting detailed description, with reference to the appended drawings. In the drawings like reference numerals will be used for like elements unless stated otherwise.
Figure 1 illustrates a flowchart of a method for forming a semiconductor structure.
Figures 2A-G schematically illustrate cross-sectional views of a semiconductor structure in different steps of a method for forming a semiconductor structure comprising a shallow trench isolation structure.
Figures 3A-E schematically illustrate cross-sectional views of a semiconductor structure in different steps of an alternative method for forming a semiconductor structure comprising a shallow trench isolation structure.

### DETAILED DESCRIPTION

In cooperation with attached drawings, the technical contents and detailed description of the present invention are described thereinafter according to a preferable embodiment, being not used to limit the claimed scope. This invention may be embodied in many different forms and should not be construed as limited to the embodiments set forth herein; rather, these embodiments are provided for thoroughness and completeness, and fully convey the scope of the invention to the skilled person.

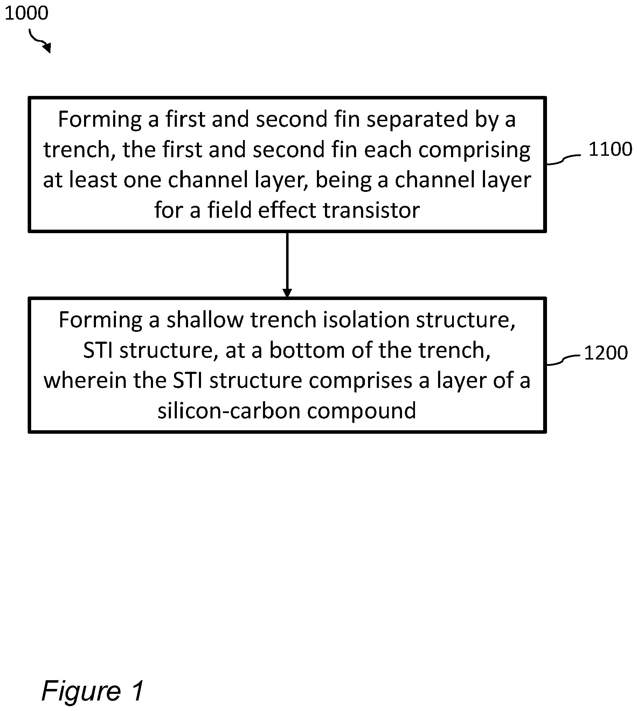

Fig. 1 illustrates a flowchart of a method 1000 for forming a semiconductor structure. The method 1000 comprises forming 1100 a first and second fin separated by a trench, the first and second fin each comprising at least one channel layer, being a channel layer for a field effect transistor; and forming 1200 a shallow trench isolation structure, STI structure, at a bottom of the trench, wherein the STI structure comprises a layer of a silicon-carbon compound.

The method 1000 may further comprise converting the first fin into a n-type field effect transistor, and converting the second fin into a p-type field effect transistor, or vice versa. The NFET and PFET of the respective first and second fins may together form parts of a complementary circuit.

Alternatively, the method 1000 may further comprise converting the first fin into a first stack of field effect transistors and the second fin into a second stack of field effect transistors, wherein each first and second stack of field effect transistors comprises a n-type field effect transistor and a p-type field effect transistor.

Although not shown in Figure 1, the method 1000 may, subsequent to forming 1200 the STI structure, further comprise: removing 1210 silicon-carbon compound from a top surface and lateral sides of the respective first and second fin; and forming 1220 a gate dielectric on the top surface and the lateral sides of the respective first and second fin. The gate dielectric may comprise a compound different from the silicon-carbon compound of the STI structure.

Alternatively, the method 1000 may further comprise forming 1230 a silicon-carbon compound gate dielectric on the top surface and lateral sides of the respective first and second fin, simultaneously with the layer of silicon-carbon compound of the act of forming 1200 the STI structure. The silicon-carbon compound gate dielectric may here comprise the same silicon-carbon compound as the STI structure.

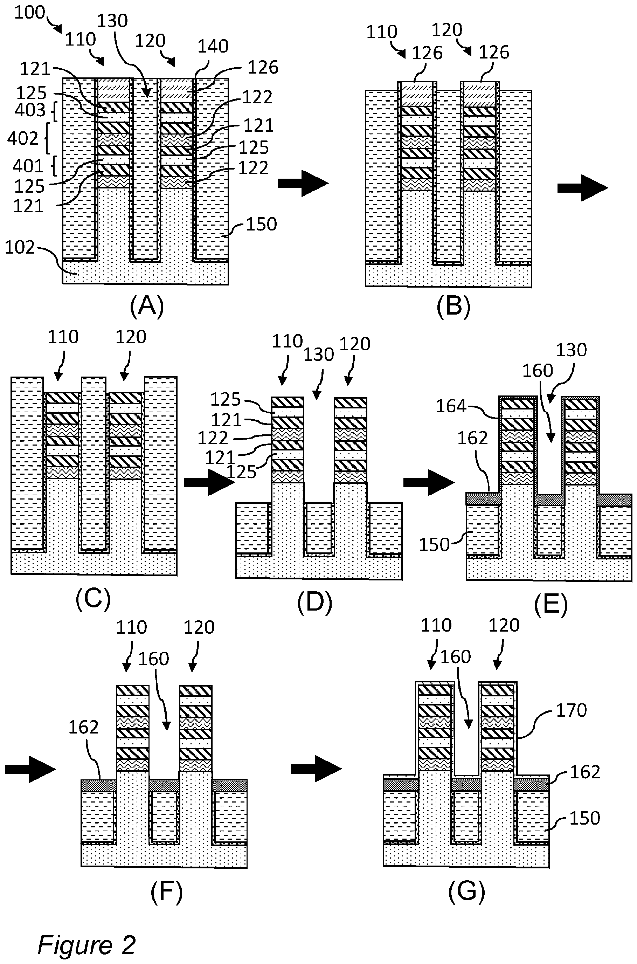

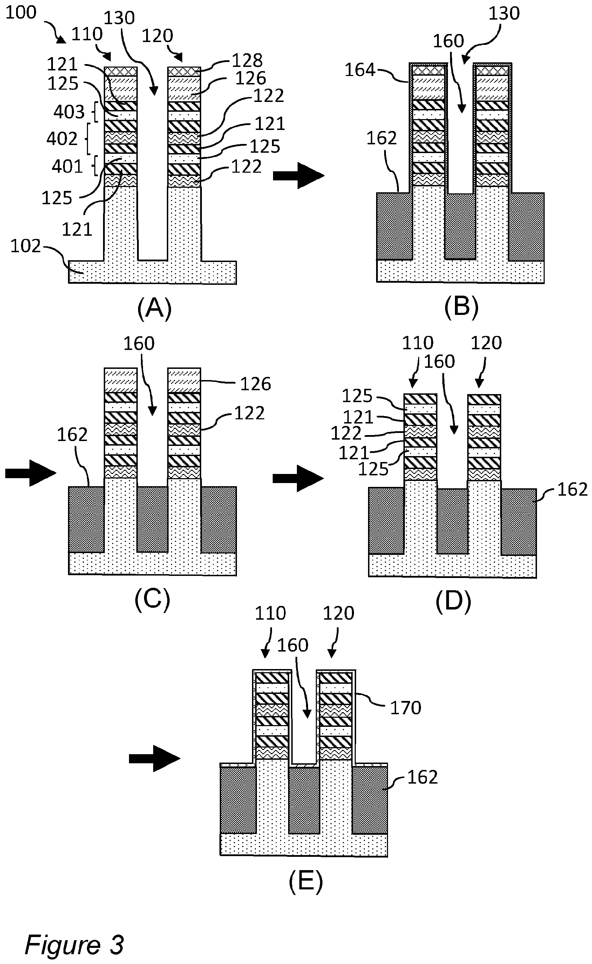

Figures 2A-G illustrate seven steps of a method for forming a semiconductor structure 100 wherein the STI structure 160 comprises a SiO₂ layer 150 with a layer of silicon-carbon compound 162 on top. Figures 3A-E illustrate five steps of an alternative method for forming a semiconductor structure 100, wherein the STI structure 160 comprises a thick layer of silicon-carbon compound 162.

In both Figures 2 and 3, a first fin 110 and a second fin 120 is illustrated with a trench 130 in-between. The fins 110, 120 are arranged on a substrate 102. Each illustrated fin comprises a layer stack comprising first sub-stack 401, a second sub-stack 402 on top of the first sub-stack 401, and a third sub-stack 403 on top of the second sub-stack 402.

The first sub-stack 401 may comprise a first sacrificial layer 121 and on the first sacrificial layer 121 a channel layer 125 defining a topmost layer of the first sub-stack 401.

The second sub-stack 402 on the first sub-stack 401 may comprise a plurality of sacrificial layers alternating between first 121 and second 122 sacrificial layers, wherein first sacrificial layers 121 define a respective bottommost and topmost layer of the second sub-stack 402, the second sub-stack 402 may comprise at least one second sacrificial layer 122.

The third sub-stack 403 on the second sub-stack 402 may comprise a channel layer 125 defining a bottommost layer of the third sub-stack 403 and a first sacrificial layer 121 on the channel layer 125.

The first sacrificial layers 121 may be formed of a first sacrificial semiconductor material, the second sacrificial layers 122 may be formed of a second sacrificial semiconductor material different from the first sacrificial semiconductor material.

Channel layers 125 of the first sub-stack 401 may be channel layers 125 for a bottom FET. Similarly, channel layers 125 of the third sub-stack 403 may be channel layers 125 for a top FET. If each fin should comprise only one FET, there may be no need for the second and third sub-stacks.

First sacrificial layers 121 may be layers that can be replaced with a gate stack during production of a stack of FETs.

Second sacrificial layers 122 may be layers that can be replaced with dielectric material during production of a stack of FETs. The dielectric material may then function as electrical isolation. For example, when the second sacrificial layer 122 of the second sub-stack 402 is replaced by dielectric material, it may function as electrical isolation between the bottom and top FET. This may be referred to as middle dielectric isolation. In the illustrations, there is also a second sacrificial layer 122 under the first sub-stack 401. When replaced with dielectric material, this may function as bottom dielectric isolation.

In the illustrations, the first and third sub-stack 403 comprises one channel layer 125 each. Alternatively, the first and third sub-stack 403 may comprise a plurality of channel layers 125 respectively.

Neighboring channel layers 125 of the first sub-stack 401 may be separated by a first sacrificial layer 121. Thus, the first sub-stack 401 may comprise a number of repeats of a first sub-stack unit, the first sub-stack unit comprising a first sacrificial layer 121 and on the first sacrificial layer 121 a channel layer 125. To exemplify, a first sub-stack comprising two first sub-stack units may be (from bottom to top): first sacrificial layer 121/channel layer 125/first sacrificial layer 121/channel layer 125.

Neighboring channel layers 125 of the third sub-stack 403 may be separated by a first sacrificial layer 121. Thus, the third sub-stack 403 may comprise a number of repeats of a third sub-stack unit, the third sub-stack unit comprising a channel layer 125 and on the channel layer 125 a first sacrificial layer 121. To exemplify, a third sub-stack 403 comprising two third sub-stack units may be (from bottom to top): channel layer 125/first sacrificial layer 121/channel layer 125/first sacrificial layer 121.

In the illustrations, the second sub-stack 402 comprises solely one second sacrificial layer 122. However, the second sub-stack 402 may comprise a plurality of second sacrificial layers 122, e.g. at least two second sacrificial layers 122 or at least three second sacrificial layers 122. To exemplify, a second sub-stack 402 comprising exactly two second sacrificial layers 122 may correspond to the following layer sequence, from bottom to top: first sacrificial layer 121/second sacrificial layer 122/first sacrificial layer 121/second sacrificial layer 122/first sacrificial layer 121. A second sub-stack 402 comprising at least two second sacrificial layers 122 is advantageous as it provides good isolation between the top and bottom FET.

The illustrated first and second fins 110, 120 further comprise a Si₃N₄ layer 126 (i.e. an etch mask 126). Further, the illustrated first and second fins 110, 120 comprises a Si₃N₄ coating 140. It is appreciated that, in writing, SiN may be used instead of Si₃N₄.

Figure 2A depicts a step wherein a deposition of SiO₂ layer 150 (using, e.g., FCVD) has been performed. The SiO₂ layer 150 here fills trenches 130 of the semiconductor structure 100.

Further, in Figure 2A, after the deposition, chemical mechanical polishing (CMP) has been performed to planarize the surface, ensuring it is flat and smooth for subsequent processing steps.

In Figure 2B, a first SiO₂ recess has been performed. The first SiO₂ recess step refers to a removal or etching of a portion of the SiO₂ layer 150 to create a recessed area. This step mainly prepares the semiconductor structure 100 for the next step of the method.

In Figure 2C, etching of the Si₃N₄ layer 126 has been performed, e.g., by using hot phosphoric acid (such as H₃PO₄). This step may, e.g., involve immersing the Si₃N₄ layer 126 in a hot phosphoric acid bath to etch away the Si₃N₄ layer 126. The etching of the Si₃N₄ layer 126 may be carried out at high temperatures to achieve the desired etch rate and selectivity, particularly ensuring that the underlying SiO₂ layer 150 is not significantly etched.

As a next step, Figure 2D depicts the semiconductor structure 100 after a second SiO₂ recess has been performed. The second SiO₂ recess step is another etching step for further adjusting the SiO₂ layer 150, creating a deeper recess. Hence, the trench 130 is here only partly filled by the SiO₂ layer 150. In particular, the SiO₂ layer 150 has been recessed to a point below the channel layers 125.

During (or after) said recessing, the coating 140 has also been removed, such that the lateral sides of the fins 110, 120 are exposed above the remaining SiO₂ layer 150.

Figure 2E depicts a STI structure 160 formed at a bottom of the trench 130. The STI structure 160 here comprises a layer of a silicon-carbon compound 162. The silicon-carbon compound may, e.g., be SiC, SiOC, and/or SiOCN. However, the silicon-carbon compound may further comprise other compounds, although the silicon-carbon compound may preferably comprise 5-35% carbon.

In Figure 2E, a silicon-carbon compound coating 164, e.g. SiOC, has been formed on a top surface and on the lateral sides of the respective first and second fin 110, 120. The silicon-carbon compound coating 164 comprises the same silicon-carbon compound as the layer of silicon-carbon compound 162 of the STI structure 160. Further, here, the silicon-carbon compound coating 164 has been formed simultaneously with the layer of silicon-carbon compound 162 of the STI structure 160. The silicon-carbon compound coating 164 may be used as a gate dielectric or it may be removed and replaced by another gate dielectric 170, as illustrated in Figures 2F-G and discussed below. If the silicon-carbon compound coating 164 is to be used as gate dielectric, the steps of Figures 2F-G may be skipped.

In particular, the STI structure 160 has here been formed by forming the SiO₂ layer 150 at the bottom of the trench 130, and subsequently forming the layer of silicon-carbon compound 162 on the SiO₂ layer 150. Hence, the STI structure 160 comprises the SiO₂ layer 150 and the layer of silicon-carbon compound 162.

In other words, the layer of silicon-carbon compound 162 caps the SiO₂ layer 150. Such a STI structure 160 may have a height or thickness below 90 nm, preferably below 50 nm. Specifically, a thickness of the layer of silicon-carbon compound 162 may be thinner than 10-50 nm, or preferably thinner than 30 nm.

The layer of silicon-carbon compound 162 and the silicon-carbon compound coating 164 may here have been formed by a first chemical vapor deposition method, CVD method, e.g. a UCVD method. The first CVD method may comprise: reacting, as a film-forming gas, an oxygen-containing silicon compound gas with a non-oxidizing hydrogen-containing gas in a state in which at least the non-oxidizing hydrogen-containing gas is plasmarized, to form a film of a flowable silanol compound; and subsequently, annealing the semiconductor structure 100 to turn the film of flowable silanol compound into the layer of silicon-carbon compound 162. The oxygen-containing silicon compound gas may, e.g., comprises Si_{α}O_{β}(O-CₘHₙ)_{Γ}CₓH_{y}, where m, n, and α are integers of 1 or more, β, Γ, x, and y are integers of 0 or more, and β and Γ are not 0 at the same time. Hence, in the above example, the SiO₂ layer 150 may here have been deposited by flowable chemical vapor deposition in the trench 130, and the layer of silicon-carbon compound 160 may have been deposited by the first CVD method. Alternatively, the layer of silicon-carbon compound 160 may be deposited by another deposition method, e.g. another chemical vapor deposition method, e.g. FCVD. If FCVD is used, the silicon-carbon compound for the STI structure may be recessed after deposition.

It is appreciated that layer of silicon-carbon compound 162 and/or the silicon-carbon compound coating 164, as well as the deposition of the SiO₂ layer 150, may be performed by other methods, e.g., ALD.

However, for the first CVD method, annealing of the layer of silicon-carbon compound 162 may be performed at a temperature below 500 °C, preferably in a range of 350 °C - 500 °C.

Figure 2F shows a step in which the silicon-carbon compound from the top surface and the lateral sides of the respective first 110 and second fin 120 has been removed. In other words, the silicon-carbon compound coating 164 has been removed. The silicon-carbon compound coating 164 may, e.g., be removed by etching.

Subsequently, Figure 2G shows how a gate dielectric 170 has been formed, or deposited, on the top surface and the lateral sides of the respective first 110 and second fin 120.

The gate dielectric 170 comprises a compound different from the silicon-carbon compound of the STI structure 160. The gate dielectric 170 may e.g. be formed by PEALD where a thin layer of a gate oxide, such as SiO₂, is deposited on the semiconductor structure 100.

Figures 3A-E illustrate five steps of an alternative method for forming a semiconductor structure 100, wherein the STI structure 160 comprises a thick layer of silicon-carbon compound 162.

Figure 3A depicts an active etch, i.e. an active area nanosheet etch, step in which the semiconductor structure 100 has been formed by removal of selected areas of material to create a desired pattern of the semiconductor structure 100.

The semiconductor structure 100 comprises a first 110 and second fin 120 that may have been formed during the active etch. The fins 110, 120 are vertical structures which may serve as the channels for current flow in a transistor.

The active etch step may define the first 110 and second fin 120 by removing material around them, leaving the fins 110, 120 standing out from the substrate 102.

The layers 121, 122, 125, 126 of the semiconductor structure 100 in Figure 3 may be the same as in Figure 2.

Hence, each fin 110, 120, comprises, on top of the substrate 102, various layers of materials deposited and patterned to form the different components of the semiconductor structure 100.

The Si₃N₄ layer 126 represents a hard mask layer 126, which is used to protect the underlying material during the etching process. The hard mask may be of a material such as Si₃N₄ or silicon oxynitride.

Further, a SiO₂ hard mask layer 128 here forms part of the first fin 110 and the second fin 120. The SiO₂ hard mask layer 128 may be used during active nanosheet patterning. The SiO₂ hard mask layer 128 is arranged on top of the Si₃N₄ layer 126.

The SiO₂ hard mask layer 128 may be preserved following the act of the active etch, and removed during a CMP process.

The etching processes can be performed using different methods, such as reactive ion etching, plasma etching, and/or sputter etch.

Figure 3B benefits from the same description as Figure 2E. In particular, a STI structure 160 has here been formed at a bottom of the trench 130 between the first 110 and second fin 120. The STI structure 160 comprises a layer of a silicon-carbon compound 162, e.g., SiC, SiOC, and/or SiOCN, or any silicon-carbon compound comprising about 5-35% carbon. The same silicon-carbon compound forms a silicon-carbon compound coating 164, e.g. SiOC, on a top surface and on lateral sides of the respective first and second fin 110, 120.

The layer of silicon-carbon compound 162, herein forming the STI structure 160, and the silicon-carbon compound coating 164 have here been formed simultaneously in the same step.

The STI structure 160 in Figure 3B is made of only the layer of silicon-carbon compound 162. Thus, the layer of silicon-carbon compound 162 has here been formed starting from the bottom of the trench 130, e.g., by the first CVD method (i.e. UCVD void-free bottom-up deposition). In other words, the layer of silicon-carbon compound 162 may have been deposited from the bottom of the trench 130, i.e. an STI floor. In particular, first CVD method may be used to form both the layer of silicon-carbon compound 162 and the silicon-carbon compound coating 164. However, the layer of silicon-carbon compound 162, and/or the silicon-carbon compound coating 164, may alternatively be formed by other deposition methods, such as ALD.

The STI structure 160, i.e. the layer of silicon-carbon compound 162, may have a height or thickness below 90 nm, preferably below 50 nm. The layer of silicon-carbon compound 162 may further be annealed at a relatively low temperature below 500 °C, preferably in a range of 350 °C - 500 °C.

Figure 3C shows a step in which the silicon-carbon compound from the top surface and the lateral sides of the respective first 110 and second fin 120 has been removed along with the SiO₂ hard mask layer 128. In other words, the silicon-carbon compound coating 164 has been removed. The silicon-carbon compound coating 164 and the SiO₂ hard mask layer 128 may be removed by etching.

In Figure 3D, the Si₃N₄ layer 126 has been removed, e.g., etched away.

Finally, in Figure 3E, a gate dielectric 170 has been formed, or deposited, on the top surface and the lateral sides of the respective first 110 and second fin 120.

The gate dielectric 170 may comprise a compound different from the silicon-carbon compound of the STI structure 160. The gate dielectric 170 may e.g. be formed by PEALD where a thin layer of a gate oxide, such as SiO₂, is deposited on the semiconductor structure 100.

It is appreciated that Figures 2E-G and 3B-E each depict a cross-sectional view of an exemplary semiconductor structure 100 comprising a first 110 and second fin 120 separated by a trench 130, and a STI structure 160 at a bottom of the trench 130. The first 110 and second fin 120 each comprise at least one channel layer 125 for a field effect transistor, and the STI structure 160 comprises a layer of a silicon-carbon compound 162. The cross-sections may be seen as cross-sections through the fins at a point between what will later be the source and drain regions.

The first fin 110 may be a n-type field effect transistor, and the second fin 120 may be a p-type field effect transistor, or vice versa. Alternatively, the first and second fin may comprise each a respective CFET. Thus, each fin may comprise a NFET stacked on top of a PFET, or vice versa.

In the above, the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method (1000) for forming a semiconductor structure, the method (1000) comprising:
forming (1100) a first and second fin separated by a trench, the first and second fin each comprising at least one channel layer, being a channel layer for a field effect transistor; and
forming (1200) a shallow trench isolation structure, STI structure, at a bottom of the trench,
wherein the STI structure comprises a layer of a silicon-carbon compound.

2. The method (1000) according to claim 1, wherein forming the STI structure comprises forming the layer of silicon-carbon compound by a first chemical vapor deposition method, CVD method, the first CVD method comprising:
reacting, as a film-forming gas, an oxygen-containing silicon compound gas with a non-oxidizing hydrogen-containing gas in a state in which at least the non-oxidizing hydrogen-containing gas is plasmarized, to form a film of a flowable silanol compound; and
subsequently, annealing the semiconductor structure to turn the film of flowable silanol compound into the layer of silicon-carbon compound,
wherein the oxygen-containing silicon compound gas comprises Si_{α}O_{β}(O-CₘHₙ)_{Γ}CₓH_{y}, wherein m, n, and α are integers of 1 or more; and wherein β, Γ, x, and y are integers of 0 or more; and β and Γ are not 0 at the same time.

3. The method (1000) according to any of the preceding claims, wherein annealing of the silicon-carbon compound is performed at a temperature below 500 °C, preferably in a range of 350 °C - 500 °C.

4. The method (1000) according to any of the preceding claims, wherein the silicon-carbon compound is SiC, SiOC, and/or SiOCN.

5. The method (1000) according to any of the preceding claims, wherein the silicon-carbon compound comprises 5-35% carbon.

6. The method (1000) according to any of the preceding claims, wherein a height of the STI structure is below 90 nm, preferably below 50 nm.

7. The method (1000) according to any of the preceding claims, wherein the act of forming the STI structure comprises:
depositing the layer of silicon-carbon compound, and
stopping said act of depositing the layer of silicon-carbon compound before a top surface of the layer of silicon-carbon compound reaches the respective at least one channel of the first and second fin.

8. The method (1000) according to any of the preceding claims, further comprising, subsequent to forming the STI structure:
removing silicon-carbon compound from a top surface and lateral sides of the respective first and second fin; and
forming a gate dielectric on the top surface and the lateral sides of the respective first and second fin, said gate dielectric comprising a compound different from the silicon-carbon compound of the STI structure.

9. The method (1000) according to any one of claims 1-7, further comprising:
forming a silicon-carbon compound gate dielectric on a top surface and lateral sides of the respective first and second fin, wherein the silicon-carbon compound gate dielectric comprises a same silicon-carbon compound as the STI structure and is formed simultaneously with the layer of silicon-carbon compound of the STI structure.

10. The method (1000) according to claim 9, wherein the act of forming the layer of silicon-carbon compound of the STI structure, and the act of forming the silicon-carbon compound gate dielectric, are performed by the first CVD method of claim 2.

11. The method (1000) according to any of the preceding claims, wherein the STI structure comprises solely the layer of silicon-carbon compound.

12. The method (1000) according to any one of claims 1-10, wherein the act of forming the STI structure comprises:
forming a layer of SiO₂ at the bottom of the trench, and
forming the layer of silicon-carbon compound on the layer of SiO₂, such that the STI structure comprises the layer of SiO₂ and the layer of silicon-carbon compound.

13. The method (1000) according to claim 12, wherein
forming the layer of SiO₂ is performed by depositing SiO₂ by flowable chemical vapor deposition in the trench and recessing the deposited SiO₂; and
forming the layer of silicon-carbon compound is performed by the first CVD method of claim 2.

14. The method (1000) according to any of the preceding claims, further comprising:
converting the first fin into a n-type field effect transistor, and converting the second fin into a p-type field effect transistor; or
converting the first fin into a first stack of field effect transistors and the second fin into a second stack of field effect transistors, wherein each first and second stack of field effect transistors comprises a n-type field effect transistor and a p-type field effect transistor.

15. A semiconductor structure (100) comprising:
a first (110) and second fin (120) separated by a trench (130), the first (110) and second fin (120) each comprising at least one channel layer (125), being a channel layer (125) for a field effect transistor; and
a shallow trench isolation structure, STI structure, (160) at a bottom of the trench (130),
wherein the STI structure (160) comprises a layer of a silicon-carbon compound (162).
